(19) Europäisches Patentamt / European Patent Office / Office européen des brevets

(11) **EP 4 534 340 A1**

(12) **EUROPEAN PATENT APPLICATION**

(43) Date of publication:
**09.04.2025 Bulletin 2025/15**

(21) Application number: **24197907.9**

(22) Date of filing: **02.09.2024**

(51) International Patent Classification (IPC):
**B60L 58/16** (2019.01)   **B60L 58/18** (2019.01)
**G01R 31/367** (2019.01)   **G01R 31/392** (2019.01)
**G01R 31/396** (2019.01)   **B60L 3/00** (2019.01)

(52) Cooperative Patent Classification (CPC):
**B60L 58/16; B60L 3/0046; B60L 58/18;
G01R 31/367; G01R 31/392; G01R 31/396;
B60L 2240/54**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.10.2023 US 202318376965**

(71) Applicant: **Hitachi, Ltd.
Tokyo 100-8280 (JP)**

(72) Inventors:
• HUYN, Nam
  **Tokyo, 100-8280 (JP)**
• KUMAR, Amit
  **Tokyo, 100-8280 (JP)**

(74) Representative: **MERH-IP Matias Erny Reichl
Hoffmann
Patentanwälte PartG mbB
Paul-Heyse-Straße 29
80336 München (DE)**

(54) **A METHOD FOR EFFICIENTLY ESTIMATING THE STATE OF HEALTH OF BATTERY CELLS AND MODULES FROM PACK-LEVEL STATE OF HEALTH**

(57)    Systems and methods described herein involve processing a battery pack to determine a structure of the battery pack and a state of health (SOH) of the battery pack; and based on the state of health of the battery pack, determining appropriate recycling, refurbishing, repurposing, or reusing instructions according to an estimated distribution of viable cell count and/or module count.

FIG. 2

**Description**

**BACKGROUND**

**Field**

The present disclosure is generally related to EV batteries, and more specifically, to battery management systems.

**Related Art**

In related art systems, it can be necessary to put a residual economic value on a EV battery pack without taking the system apart to access its internal components. Consider as a use case retired or end- of-life EV battery pack management, where an OEM looks for opportunities for repurposing/refurbishing/recycling (Re*) retired batteries. To maximize the recovery value of a battery pack that can be extracted from Re* providers, accurate estimation of the number of good battery cells or modules inside the pack is desirable. While only the SOH (state of health) of the battery pack can be measured, there is a need to estimate the SOH of battery cells or modules without disassembling the pack.

Most EV batteries come with a battery management system (BMS) that is designed to monitor the overall health of a battery. Many BMS's can monitor and report the SOH at the pack level but seldom at the cell or module level, especially for large battery packs containing thousands of cells.

There are also cases where the SOH cannot be obtained through a BMS, not even at the pack level. For example, the BMS may not be capable of sharing data with the external environment. In these cases, there are external testing instruments designed to measure the SOH of a battery pack, but not the SOH of the cells inside the pack. Even if a battery pack can be disassembled into cells, using these instruments to test all individual cells would be prohibitively time consuming and would not scale with high volumes of retired batteries.

**SUMMARY**

In the related art, there are no implementations for inferring cell-level or module-level SOH from pack-level SOH.

As a common situation, the SOH (state of health) of a system as a whole (composite system) can be assessed externally, but the internal parts of the system (components) are not directly observable or accessible and yet their SOH still needs to be assessed. When the composite structure is known, we can leverage this knowledge to infer the SOH of the parts given the SOH of the whole system. This problem arises in end-of-life electric vehicle (EV) battery remaining economic value assessment use case, where the SOH of battery pack may be measurable but the SOH of the battery cells inside the pack is not directly measurable without disassembling the pack. While the SOH of the battery cells cannot be known precisely, a prior probability distribution of their SOH is assumed. In the most conservative case when no information about these cells are available, a uniform prior probability distribution can be used.

To appreciate the challenges this problem raises, consider the following potential solution methods:

Inferring the SOH of parts of a system (components), given the SOH of the system as a whole (composite), can be framed as computing a conditional probability of component health given composite health. For example, given a system $Z$ composed of parts $X$ and $Y$, the expected number of good cells in $Z$ can be expressed as:

$$\int goodcells\ (x,y)\ \text{x}\ Pr(x,y\ \mid\ ha(x,y)\ =\ z)\ dxdy$$

where $x$, $y$, $z$ denote capacities, $goodcells$ $(x, y)$ denotes the number of good cells in $Z$, $ha$ $(X, Y)$ denotes the SOH of composite $(X, Y)$, and $Pr(x, y \mid ha(x,y) = z)$ denotes the conditional joint density of $(X, Y)$ given $ha(X, Y) = z$. Finding a closed-form solution for this conditional joint density problem is a very appealing idea. For the parallel case, a closed-form solution for $Pr(x, y \mid (x + y) = z)$ exists under some assumption: if $X$ and $Y$ are jointly normal with mean $\mu$ and covariance $\Sigma$, then the conditional joint density we are looking for is also normal with mean $\mu + \frac{z - \mu'T}{T'\Sigma T}\Sigma T$ and covariance $\Sigma - \frac{1}{T'\Sigma T}\Sigma T\ (\Sigma T)'$, where $T = (1,1)'$. However, without this normality assumption, it is not known whether a closed-form solution still exists. For the serial case, the existence of a closed-form solution for $Pr(x,y \mid Min(x,y) = z)$ is also an open problem. So, while the prospect of a closed-form solution is appealing, the existence of a closed-form solution does not look very promising, even for the simplest cases. Furthermore, even if a closed-form solution for the density exists, a closed-form solution for its continuous integration may not exi st.

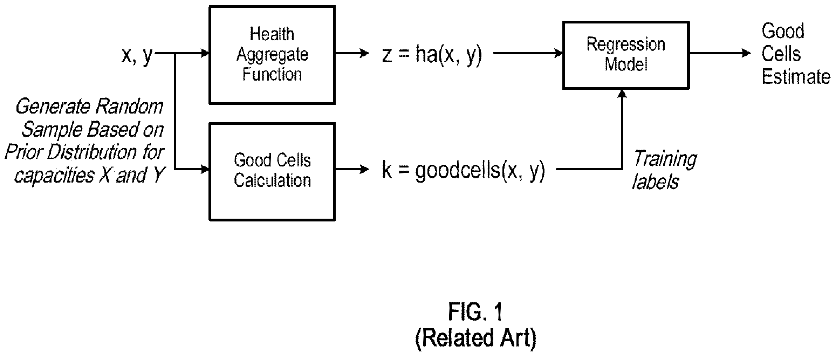

Alternatively, consider an approach that makes no assumptions about the probability distribution of cell capacities and that accepts any function $ha$ (. ) that is computable. Inspired by the Monte-Carlo simulation class of methods, capacity values for all cells are randomly generated and the corresponding values for $ha(.)$ and $goodcells(.)$ can be derived. FIG. 1 illustrates an example of the Monte-Carlo-based approach to good cell count estimation in the related art.

First compute data pairs $[z = ha(x, y), k = goodcells(x, y)]$ from randomly generated $x$ and $y$ values. The collection of these pairs $[z, k]$ is then used to train the good cell count estimator, a regression predictive model with $z$ as predictor and $k$ as outcome.

While this Monte-Carlo-based approach is very general and completely data-driven - the more data generated and used to build the model, the more accurate the estimation will be - it can be prohibitively expensive to compute and therefore ruled out for use in practical applications.

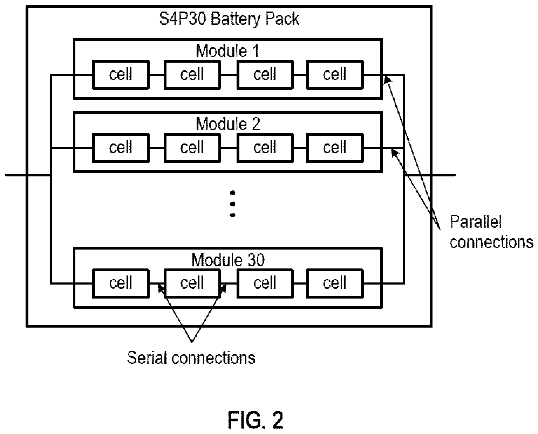

Example implementations described herein involve a probabilistic method for inferring the SOH of the parts of a system (components) from the SOH of the system as a whole (composite), based on the composite structure, which is assumed to be known. As an example of inference, the probability distribution for the number of good battery cells (good can be defined as say SOH >= 80%) can be determined given the SOH of the battery pack. Most EV battery packs follow a simple series-parallel design scheme. FIG. 2 illustrates an example of the series/parallel structure of a S4P30 battery pack, in accordance with an example implementation.

The example implementations described herein assume that the structure of the composite system is known. Regarding the components whose SOH need to be inferred, the prior SOH probability distribution is also presumed to be known. In the absence of any information, a uniform distribution to represent this lack of information is utilized.

Example implementations described herein can be used to infer the SOH of the battery cells or modules such as good cell count and good module count, given the SOH of the battery pack. Although the example implementations described herein are directed to estimate battery SOH, the example implementations described herein can also be used to estimate battery discharge rate which can be used to assess battery performance and to optimize cell balancing strategies.

Aspects of the present disclosure can involve a method, which can involve determining a structure of the battery pack (e.g., by looking up a product design catalog) and a state of health (SOH) of the battery pack (e.g., using BMS, battery test equipment, or data-driven prediction method); for the state of health of the battery pack being within a first range of the viable range, determining a posterior distribution of viable cell count for the battery pack from the structure of the battery pack, the SOH of the battery pack, and a prior probability distribution of a SOH of cells in the battery pack; and providing the posterior distribution of viable cell count and instructions to refurbish; for the state of health of the battery pack being within a second range of the viable range, the second range being higher than the first range, determining a posterior distribution of viable module count for the battery pack from the structure of the battery pack, the battery pack state of health, and a prior probability distribution of SOH of modules in the battery pack; and/or providing the posterior distribution of viable module count and instructions to repurpose.

Aspects of the present disclosure can involve a computer program, which can involve instructions involving determining a structure of the battery pack and a state of health (SOH) of the battery pack; for the state of health of the battery pack being within a first range of the viable range, determining a posterior distribution of viable cell count for the battery pack from the structure of the battery pack, the SOH of the battery pack, and a prior probability distribution of a SOH of cells in the battery pack; and providing the posterior distribution of viable cell count and instructions to refurbish; for the state of health of the battery pack being within a second range of the viable range, the second range being higher than the first range, determining a posterior distribution of viable module count for the battery pack from the structure of the battery pack, the battery pack state of health, and a prior probability distribution of SOH of modules in the battery pack; and/or providing the posterior distribution of viable module count and instructions to repurpose. The computer program and instructions can be stored on a non-transitory computer readable medium and executed by one or more processors.

Aspects of the present disclosure can involve a system, which can involve means for determining a structure of the battery pack and a state of health (SOH) of the battery pack; for the state of health of the battery pack being within a first range of the viable range, means for determining a posterior distribution of viable cell count for the battery pack from the structure of the battery pack, the SOH of the battery pack, and a prior probability distribution of a SOH of cells in the battery pack; and means for providing the posterior distribution of viable cell count and instructions to refurbish; for the state of health of the battery pack being within a second range of the viable range, the second range being higher than the first range, means for determining a posterior distribution of viable module count for the battery pack from the structure of the battery pack, the battery pack state of health, and a prior probability distribution of SOH of modules in the battery pack; and/or means for providing the posterior distribution of viable module count and instructions to repurpose.

Aspects of the present disclosure can involve an apparatus, which can involve a processor, configured to determine a structure of the battery pack and a state of health (SOH) of the battery pack; for the state of health of the battery pack being within a first range of the viable range, determine a posterior distribution of viable cell count for the battery pack from the structure of the battery pack, the SOH of the battery pack, and a prior probability distribution of a SOH of cells in the battery pack; and provide the posterior distribution of viable cell count and instructions to refurbish; for the state of health of the battery pack being within a second range of the viable range, the second range being higher than the first range, determine a posterior distribution of viable module count for the battery pack from the structure of the battery pack, the battery pack state of health, and a prior probability distribution of SOH of modules in the battery pack; and/or provide the posterior distribution of viable module count and instructions to repurpose.

## BRIEF DESCRIPTION OF THE DRAWINGS

FIG. 1 is an illustration of the Monte-Carlo-based approach to good cell count estimation, in accordance with the related art.

FIG. 2 illustrates an example of the series/parallel structure of a S4P30 battery pack, in accordance with an example implementation.

FIG. 3 illustrates the discrete representation for state-of-health random variables, in accordance with an example implementation.

FIG. 4 illustrates the structural induction over battery part-whole hierarchy for inference, in accordance with an example implementation.

FIG. 5 illustrates the dynamic programming method to solve the problem in a bottom-up fashion, using a simple layering strategy, in accordance with an example implementation.

FIG. 6 illustrates the dynamic programming to solve the problem in a computation sequence, using a more elaborate layering strategy, in accordance with an example implementation.

FIG. 7 illustrates the tensor formulation to parallelize computations, in accordance with an example implementation.

FIG. 8 illustrates a flowchart for an algorithm to estimate good cell counts using a simple dynamic programming linear layering strategy, in accordance with an example implementation.

FIG. 9 illustrates the estimated good cell count and the good module count as a function of the pack-level SOH, in accordance with an example implementation.

FIG. 10 illustrates an example processing system for a battery pack, in accordance with an example implementation.

FIG. 11 illustrates an example computing environment with an example computer device suitable for use in some example implementations.

## DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of the ordinary skills in the art practicing implementations of the present application. Selection can be conducted by a user through a user interface or other input means, or can be implemented through a desired algorithm. Example implementations as described herein can be utilized either singularly or in combination, and the functionality of the example implementations can be implemented through any means according to the desired implementations.

The notation for the present disclosure is given as follows.

For the battery use case, $S_mP_n$ is used to denote a battery pack that consists of $n$ modules connected in parallel, where each module consists of m cells connected in series. The running example uses S8P4 to denote a pack including four parallel modules where each module includes eight cells in series.

X, Y, Z is used to denote batteries (i.e. battery composites that have a state of health (SOH)). They can be battery components at any level: cell, module, or pack. When Z is stated to be composed of X and Y, this decomposition can be physical (e.g., Z is a battery pack that involves two modules X and Y connected in parallel) or logical (e.g., Z represents five cells connected in series and can be viewed as composed of X and Y connected in series, where X represents two cells connected in series and Y represents three cells connected in series). This logical way to decompose a system allows the conducting of reasoning about any part of a composite system.

While X is used to denote a battery, we use the same notation X herein to denote a random variable for the SOH of battery X. The meaning of the notation should be clear enough based on the context of use throughout the present disclosure.

Example implementations described herein involve four elements: (1) Use of a discrete representation for state-of-health random variables, (2) use of structural induction over battery part-whole hierarchy for inference, (3) use of dynamic programming to solve problem in a bottom-up fashion, and (4) use of tensor formulation to parallelize computations. The details of these four elements are described as follows.

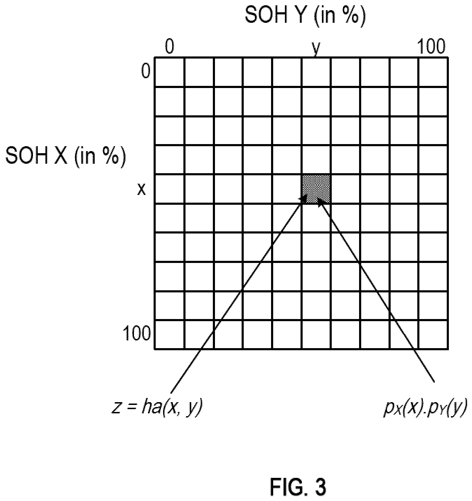

FIG. 3 illustrates the discrete representation for state-of-health random variables, in accordance with an example implementation. A discrete formulation is used where all state-of-health random variables of interest, such as X and Y, are discretized. This helps to avoid solving continuous integration problems which may have no solution. Any resolution can be used for discretization. In representing battery SOH as a percentage value, precision at the fractional level is not needed, so SOH can be represented as integer values 0, 1, $\cdots$, 100.

In any case, the validity of the method is independent of the chosen resolution. Let $ha(x, y)$ be a generic health-aggregate function. When X and Y are connected in series, $ha(x, y) = \min(x, y)$. When X and Y are connected in parallel, $ha(x, y) = \text{mean}(x, y)$ for the special case where X and Y have identical rated capacities. In the general case, $ha(x, y) = \text{weightedMean}(x, y)$ where the weights are the rated capacities.

For a battery X, $p_x(x)$ is used to denote the probability distribution of its SOH variable X, (i.e., the probability that SOH $X = x$) and x denotes a SOH value expressed as a percentage in the example shown in FIG. 3. Let $N_X$ be a random variable that represents the number of good cells in battery X and $n_x(x) = \mathbb{E}(N_x \mid X = x)$ be the expected number of good cells in X conditioned on SOH $X = x$. This specific random variable is used only to illustrate the method. Other random variables (such as module counts) and other statistics (such as standard deviation) could also be used in accordance with the desired implementation, and the present disclosure is not limited thereto.

In the second element, there is a use of structural induction over a part-whole hierarchy, leveraging on the knowledge of the internal structure of a composite battery system.

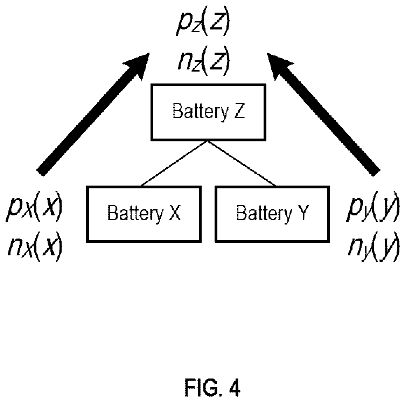

FIG. 4 illustrates the structural induction over battery part-whole hierarchy for inference, in accordance with an example implementation. In structural induction, there is a need to specify a base case and an inductive step:

Base case where X is a battery cell: $p_x(x)$ is assumed to be given. If nothing is known, use a uniform discrete distribution, that is, for x = 0, 1, ... , 100: $p_x(x) = 1/101$.

$n_x(x) = 1_{x \geq 80}$, the characteristic function for $x \geq 80$.

Inductive step where Z has components X and Y: with x, y, z taking on integer values 0, 1, ... , 100, $p_z(z)$ can be expressed in terms of $p_x(x)$ and $p_y(y)$ as follows:

$$p_z(z) = \sum_{x,y:ha=z} p_x(x).p_y(y) = \sum_{x=0}^{100} \sum_{y=0}^{100} 1_{ha(x,y)=z} \, p_x(x)p_y(y)$$

$$n_z(z) = \sum_{x,y:ha(x,y)=z} (n_x(x) + n_y(y)). \frac{p_x(x).p_y(y)}{p_z(z)}$$

In a third element, there is a use of dynamic programming to solve the problem from the bottom-up. This helps not only cut down the combinatorics, but also achieve computation sequences of length *Log* in the number of parts. Using a S8P4 battery structure as an example, the computation can be sequenced in multiple ways.

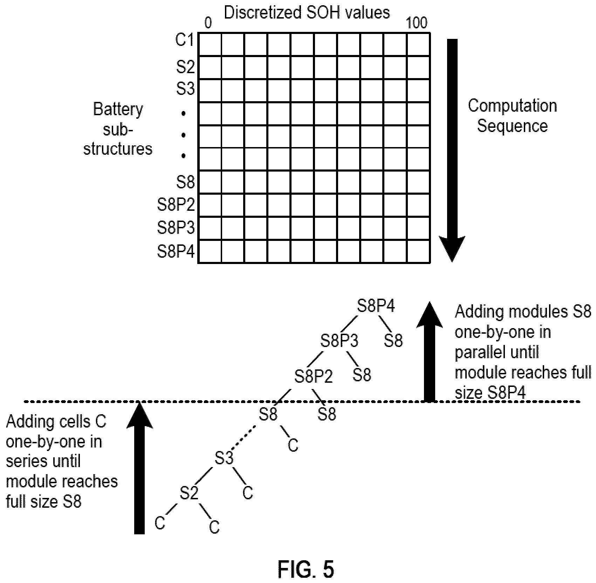

FIG. 5 illustrates the dynamic programming to solve problem in a bottom-up fashion, in accordance with an example implementation. In the simplest way, a linear dynamic programming layering strategy is used as illustrated in FIG. 5.

Using this simple layering strategy, a $O(m + n)$ linear time complexity is achieved for a $S_m P_n$ battery.

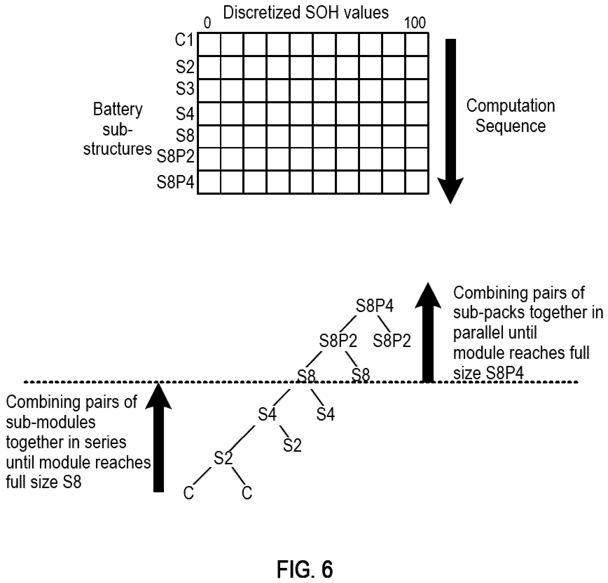

FIG. 6 illustrates the dynamic programming to solve the problem in a computation sequence, in accordance with an example implementation, using a more efficient balanced layering strategy to carry out dynamic programming.

Using this more elaborate layering strategy, an $O(\log(m) + \log(n))$ log time complexity for a $S_m P_n$ battery can be achieved.

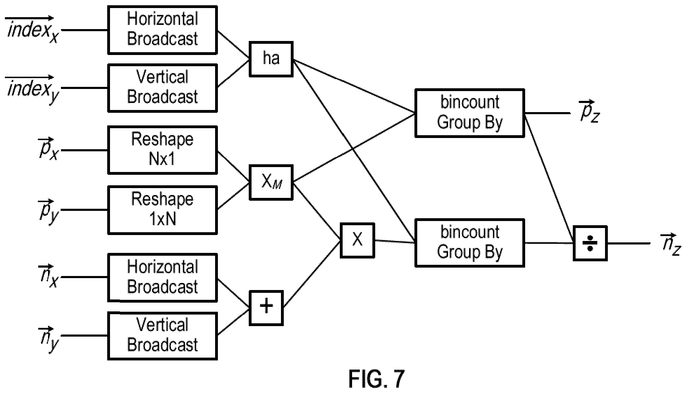

FIG. 7 illustrates the tensor formulation to parallelize computations, in accordance with an example implementation. In an example of the fourth element, there is the use of tensor formulation to parallelize computations. By computing on vectors and matrices instead of sequentially on individual data elements, the overall computations are not only sped up, but the example implementations also minimize the dependency of time complexity on the resolution used for discretization. Referring to the matrix examples shown under dynamic programming, an entire row of 101 values is a vector which can be computed in one shot. The example of FIG. 7 shows a tensor flow graph for the estimation of vectors $\vec{p}_z$ and $\vec{n}_z$ in a tensor formulation, where nodes represent tensor operators that operate on vectors and matrices.

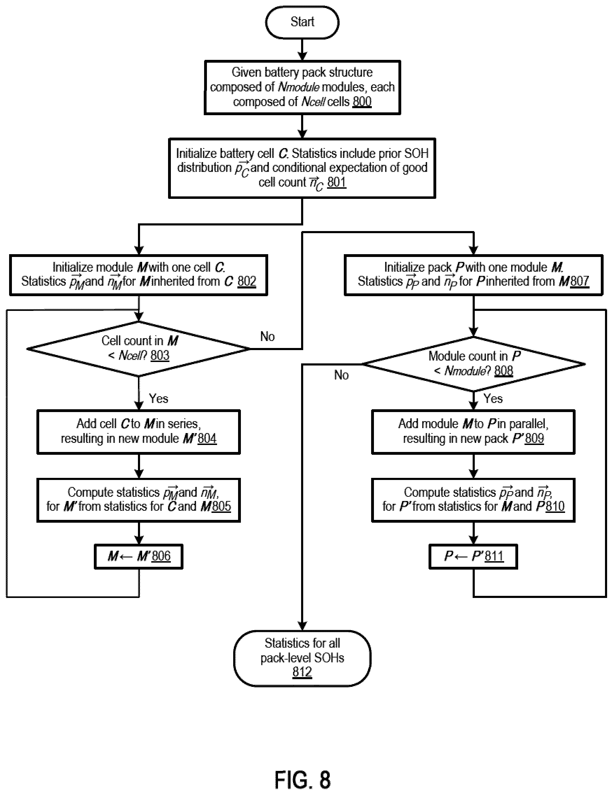

FIG. 8 illustrates a flowchart for an algorithm to estimate good cell counts using a simple dynamic programming linear layering strategy, in accordance with an example implementation.

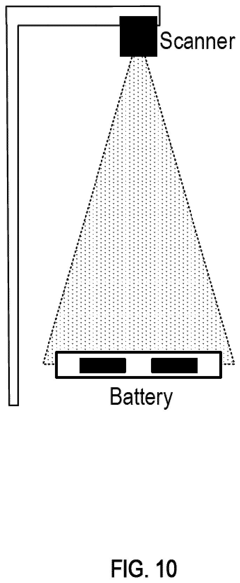

At first at 800, the battery pack structure is provided from a scan of the battery pack as described in FIG. 10. The battery pack structure will be composed of *Nmodule* modules, each composed of *Ncell* cells.

At 801, the flow initializes battery cell *C*. Statistics include prior SOH distribution $\vec{p}_C$ and conditional expectation of good cell count $\vec{n}_C$.

From 802 to 806, the module is processed in an iterative manner through adding cells iteratively. At 802, the flow starts with a module initialized with one cell. The statistics for the module are inherited from the cell as the module is composed only of the cell. At 803, a check is made as to whether the cell count for a module has exceeded the number of cells in the structure. If so (No), then processing of the module is completed and the flow proceeds to 807, otherwise (Yes) the flow proceeds to 804 to add a cell to the module in series to result in a new cell. At 805, the new cell statistics are computed from the statistics of the cell and from the module. At 806, the new module is then used as the module, and the flow reiterates from 803 to add another cell. From this manner, the statistics of the module are computed in a bottom up manner from the statistics of the cells as added one by one.

From 807 to 811, the battery pack is processed in an iterative manner through adding modules iteratively. At 807, the flow initializes battery pack *P* with only one module as computed from the flow from 802 to 806. The statistics from the pack are inherited from the module as the pack is initialized with only the single module.

At 808, a determination is made as to whether the module count for the battery pack exceeds the number of modules in the structure. If so (No) the processing of the battery pack is completed and the statistics for all of the pack level SOHs is provided at 812. Otherwise (Yes), the flow proceeds to 809 to add a module to the pack in parallel to result in a new battery pack. At 810, the statistics are computed for the new battery pack from the module statistics and the battery pack statistics. At 811, the new battery pack is then used as the battery pack, and the flow reiterates from 808 to add another module. In this manner, the statistics of the battery pack are computed in a bottom up manner from the statistics of the modules as added one by one.

In the context of EV battery circular economy and battery repurposing in particular, the example implementations described herein allow the user to quickly determine the market value of a battery pack by estimating the number of good cells or modules inside, given the SOH of the pack, without requiring the pack to be disassembled. The latter is important because it saves both work (manual disassembly and reassembly can be time consuming and cannot be easily scaled up) and the technical skills needed (batteries may not be designed for ease of disassembly and thus requires disassembly instructions which may not be readily available).

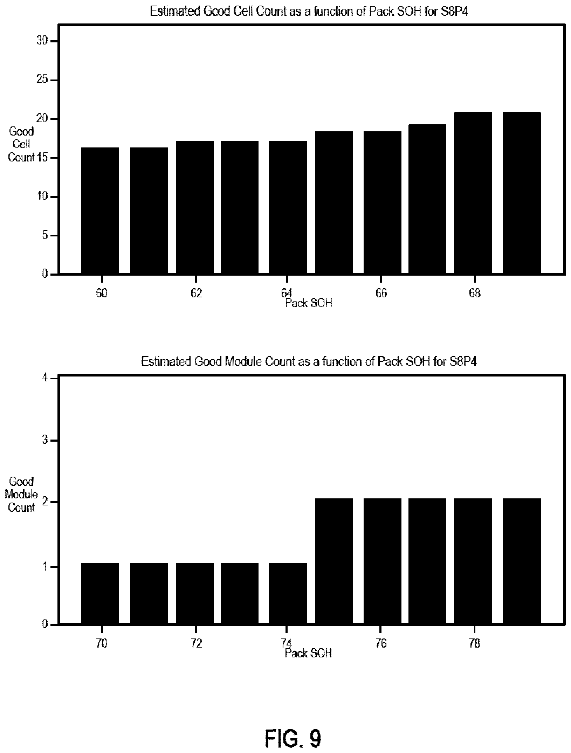

FIG. 9 illustrates the estimated good cell count and the good module count as a function of the pack-level SOH, in accordance with an example implementation. The proposed method can be used to estimate the number of good components at any level of the battery part-whole hierarchy. For example, if a battery pack involves modules and a module involves cells, the number of good cells as well as the number of good modules can be estimated. As an example, consider the S8P4 battery pack to illustrate how example implementations can be applied to determining Re* opportunities. If the pack-level SOH falls between 60% and 69%, the example implementations can be used to estimate number of good cells (cell SOH $\geq$ 80%), as needed in the refurbishing use case. Assuming uniform prior cell SOH distribution, the top graph of FIG. 9 shows the estimated good cell count as a function of the pack-level SOH.

However, if the pack-level SOH falls between 70% and 79%, an opportunity of repurposing the battery presents itself and requires an estimate of the number of good modules (module SOH $\geq$ 80%), which can be found by the example implementations described herein. Assuming uniform prior module SOH distribution, the bottom graph of FIG. 9 depicts the estimated good module count as a function of the pack- level SOH.

Moreover, the example implementations described herein allow for routing of the high-remaining-value EOL batteries directly from dealers/repair shops to repurposing/refurbishing providers, hence reducing transportation, handling, and storage costs compared to the current process where EOL batteries are first brought to an OEM's warehouse and then shipped to Recycling or repurposing providers.

The example implementations can be extended to the estimation of other useful statistics as follows. One example is good cell count variance, to express point estimation uncertainties using 95% prediction intervals. Another example is the expected market value of cells when a pricing model for used cells is available. Another example is the means and variances for module counts, expected market value for modules.

Other statistical inferences that can be developed using the example implementations described herein. Further, the applicability of the example implementations described herein can be broadened to composite systems other than batteries and to estimating KPIs (Key Performance Indicators) other than SOH, such as any composite systems (not necessarily batteries) that have a hierarchical structure and KPI metrics (instead of SOH for batteries) that can be composed.

In an example, there can be a use case involving battery KPIs other than SOH, such as temperature, to detect thermal runaway at cell-level from temperature measurements at pack level. Another example KPI is a battery discharge rate, whose estimate can be used to assess battery performance and to optimize cell balancing strategies.

Besides the circular economy use case of end-of-life EV battery management, the example implementations can also be applied to other use cases, such as Grid-level BESS applications (instead of EV applications), market value estimation for used car parts and EV batteries for dismantlers, and insurance premium pricing applications.

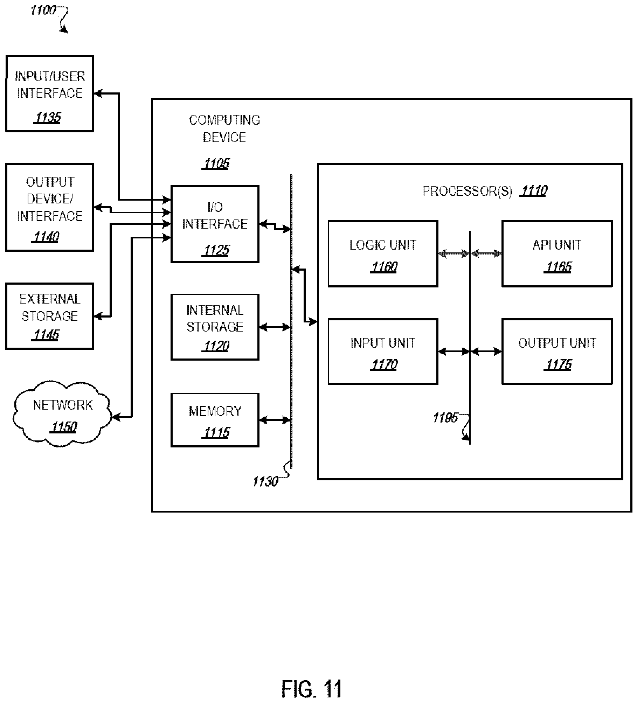

FIG. 10 illustrates an example processing system for a battery pack, in accordance with an example implementation. In the example processing system of FIG. 10, a battery pack can be transported (e.g., via conveyor belt, via cart, etc.) under a scanner to scan information regarding the battery pack. The scanner will scan the battery pack (e.g. a bar code, an RFID tag, etc.) to identify the manufacturer and OEM information, from which a database can be referenced to obtain the structure of the battery pack, including cell and module information and the prior SOH probability distribution information of the cell or modules, which can then be provided to a server such as the computer device as illustrated in FIG. 11. In another example implementation, the scanning can involve using a camera (e.g., the scanner is a camera) to identify the product ID which will be used to lookup a design database for the battery structure. In another example implementation a battery tester can be connected to the battery pack to measure the pack-level SOH.

The battery pack itself may also store information regarding the SOH of the battery pack, by means of a battery management system, which can also be read out and provided to the server. In example implementations, a database can be maintained to manage all known probability distributions and structures of battery packs based on OEM information, and can also store SOH information from scanned batteries according to their battery identifier.

FIG. 11 illustrates an example computing environment with an example computer device suitable for use in some example implementations. Computer device 1105 in computing environment 1100 can include one or more processing units, cores, or processors 1110, memory 1115 (e.g., RAM, ROM, and/or the like), internal storage 1120 (e.g., magnetic, optical, solid state storage, and/or organic), and/or I/O interface 1125, any of which can be coupled on a communication mechanism or bus 1130 for communicating information or embedded in the computer device 1105. I/O interface 1125 is also configured to receive images from cameras or provide images to projectors or displays, depending on the desired implementation.

Computer device 1105 can be communicatively coupled to input/user interface 1135 and output device/interface 1140. Either one or both input/user interface 1135 and output device/interface 1140 can be a wired or wireless interface and can be detachable. Input/user interface 1135 may include any device, component, sensor, or interface, physical or virtual, that can be used to provide input (e.g., buttons, touch-screen interface, keyboard, a pointing/cursor control, microphone, camera, braille, motion sensor, optical reader, and/or the like). Output device/interface 1140 may include a display, television, monitor, printer, speaker, braille, or the like. In some example implementations, input/user interface 1135 and output device/interface 1140 can be embedded with or physically coupled to the computer device 1105. In other example implementations, other computer devices may function as or provide the functions of input/user interface 1135 and output device/interface 1140 for a computer device 1105.

Examples of computer device 1105 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 1105 can be communicatively coupled (e.g., via I/O interface 1125) to external storage 1145 and network 1150 for communicating with any number of networked components, devices, and systems, including one or more computer devices of the same or different configurations. Computer device 1105 or any connected computer device can be functioning as, providing services of, or referred to as a server, client, thin server, general machine, special-purpose machine, or another label.

I/O interface 1125 can include, but is not limited to, wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 1100. Network 1150 can be any network or combination of networks (e.g., the Internet, local area network, wide area network, a telephonic network, a cellular network, satellite network, and the like).

Computer device 1105 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid state media (e.g., RAM, ROM, flash memory, solid-state storage), and other non-volatile storage or memory.

Computer device 1105 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 1110 can execute under any operating system (OS) (not shown), in a native or virtual environment. One or more applications can be deployed that include logic unit 1160, application programming interface (API) unit 1165, input unit 1170, output unit 1175, and inter-unit communication mechanism 1195 for the different units to communicate with each other, with the OS, and with other applications (not shown). The described units and elements can be varied in design, function, configuration, or implementation and are not limited to the descriptions provided. Processor(s) 1110 can be in the form of hardware processors such as central processing units (CPUs) or in a combination of hardware and software units.

In some example implementations, when information or an execution instruction is received by API unit 1165, it may be communicated to one or more other units (e.g., logic unit 1160, input unit 1170, output unit 1175). In some instances, logic unit 1160 may be configured to control the information flow among the units and direct the services provided by API unit 1165, input unit 1170, output unit 1175, in some example implementations described above. For example, the flow of one or more processes or implementations may be controlled by logic unit 1160 alone or in conjunction with API unit 1165. The input unit 1170 may be configured to obtain input for the calculations described in the example implementations, and the output unit 1175 may be configured to provide output based on the calculations described in the example implementations.

Processor(s) 1110 can be configured to execute a method or computer instructions for processing a battery pack as illustrated in FIG. 8 to FIG. 10, which can involve determining a structure of the battery pack and a state of health (SOH) of the battery pack. The determination of the structure of the battery pack can be conducted for example, as described in FIG. 10 by scanning the barcode or QR code of the battery pack to lookup a database to associate the battery ID to its structure. In another example implementation, if the battery pack can involve a modern battery management system, the battery pack state of health can be obtained directly from the battery management system. For the SOH of the battery pack being within a first range of the viable range, processor(s) 1110 can be configured to execute a method or instructions involving determining a posterior distribution of viable cell count for the battery pack from the structure of the battery pack (e.g., a number of modules connected in parallel and a number of cells connected in series), the SOH of the battery pack, and a prior probability distribution of a SOH of cells in the battery pack; and providing the posterior distribution of viable cell count and instructions to refurbish. The first range of the viable range for refurbishing can be set according to the battery chemistry and the current refurbishing market. As an example, the first range can be 60%-70%. For the SOH of the battery pack being within a second range of the viable range, the second range being higher than the first range, processor(s) 1110 can be configured to execute a method or instructions involving determining a posterior distribution of viable module count for the battery pack from the structure of the battery pack (e.g., a number of modules connected in parallel), the SOH of the battery pack, and a prior probability distribution of SOH of modules in the battery pack; and providing the posterior distribution of viable module count and instructions to repurpose. The second range for repurposing can be set based on the battery chemistry and the current repurposing market. As an example, the second range can be 70-80%. Further, the instructions to repurpose modules can include integrating the modules into a refurbished pack, or reusing the modules in a second life application such as a golf cart, e-scooter, e-bike, or otherwise in accordance with the desired implementation.

Processor(s) 1110 can be configured to execute the method or instructions as described above, and further involve, for the SOH of the battery pack being below the viable range, providing instructions to recycle the battery pack. The lower threshold of the viable range can be set based on battery chemistry and the current recycling market. For example, below the viable range can mean <60%.

Processor(s) 1110 can be configured to execute the method or instructions as described above, and further involve, for the SOH of the battery pack being above the viable range, providing instructions to reuse the battery pack as-is and an estimated end of life. If the battery pack has a range above the viable range, it indicates that the battery pack is still usable for its current purpose, and can therefore be reused. The estimated end of life can be calculated in accordance with any known desired implementation based on the distribution of SOH of modules in the battery pack.

Processor(s) 1110 can be configured to execute the method or instructions as described above, wherein the determining the posterior distribution of viable cell count and the determining the posterior distribution of viable module count is determined from a discrete representation of the distribution of viable cell count and the distribution of viable module count based on the structure of the battery pack, the SOH of the battery pack, and the prior probability distribution of the SOH of the cells or the modules in the battery pack as described with respect to FIGS. 3 and 4.

Processor(s) 1110 can be configured to execute the method or instructions as described above, wherein the determining the posterior distribution of viable cell count and the determining the posterior distribution of viable module count is conducted from an inductive process that determines probability of viability of the cells in the battery pack from the prior probability distributions of the SOH of the cells and the SOH of the battery pack, probability of viability of the modules in the battery pack from the prior probability distributions of the SOH of the modules and the SOH of the battery pack, the inductive process being based on the structure of the battery pack as described with respect to FIG. 4.

Processor(s) 1110 can be configured to execute the method or instruction as described above, wherein the determining the posterior distribution of viable cell count and the determining the posterior distribution of viable module count is determined from a tensor formulation with the distribution of viable cell count and the distribution of viable module count being in a form of vectors, with nodes of a tensor graph of the tensor formulation representing tensor operators that operate on the vectors and matrix representations of the (a) probability distribution of the SOH of the cells, the modules, and other substructures in the battery pack and (b) expected viable cell count or viable module count in substructures of the battery pack as described with respect to FIG. 7.

Processor(s) 1110 can be configured to execute the method or instructions as described above, wherein the determining the posterior distribution of viable cell count and the determining the posterior distribution of viable module count is conducted through a dynamic programming process can involve initializing a module with a cell; adding a cell to the module in series to formulate a new larger module and computing statistics for the new module given the state of health and statistics for the cell until a defined number of cells is reached; initializing the battery pack with a module having the probability distribution of the SOH of the module and the expected viable cell count in the module; adding a module to the battery pack in parallel to formulate a new larger battery pack and computing statistics for the new battery pack given the state of health and statistics for the module and for the new larger battery pack until a defined number of modules is reached as described with respect to FIGS. 5 and 6.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer-readable storage medium or a computer-readable signal medium. A computer-readable storage medium may involve tangible mediums such as, but not limited to optical disks, magnetic disks, read-only memories, random access memories, solid state devices and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the techniques of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general-purpose computer, based on instructions stored on a computer-readable medium. If desired, the instructions can be stored on the medium in a compressed and/or encrypted format.

Moreover, other implementations of the present application will be apparent to those skilled in the art from consideration of the specification and practice of the techniques of the present application. Various aspects and/or components of the described example implementations may be used singly or in any combination. It is intended that the specification and example implementations be considered as examples only, with the true scope and spirit of the present application being indicated by the following claims.

**Claims**

1. A method for processing an electric vehicle (EV) battery pack, comprising:

   determining a structure of the battery pack and a state of health (SOH) of the battery pack;
   for the SOH of the battery pack being within a first range of the viable range:

   determining a posterior distribution of viable cell count for the battery pack from the structure of the battery pack, the SOH of the battery pack, and a prior probability distribution of the SOH of cells in the battery pack; and
   providing the posterior distribution of viable cell count and instructions to refurbish; and

   for the SOH of the battery pack being within a second range of the viable range, the second range being higher than the first range:

   determining a posterior distribution of viable module count for the battery pack from the structure of the battery pack, the SOH of the battery pack, and a prior probability distribution of the SOH of modules in the battery pack; and
   providing the posterior distribution of viable module count and instructions to repurpose.

2. The method of claim 1, wherein for the SOH of the battery pack being below the viable range, providing instructions to recycle the battery pack.

3. The method according to at least one of the previous claims, wherein for the SOH of the battery pack being above the viable range, providing instructions to reuse the battery pack and an estimated end of life.

4. The method of according to at least one of the previous claims, wherein the determining the posterior distribution of viable cell count and the determining the posterior distribution of viable module count is determined from a discrete representation of the distribution of viable cell count and the distribution of viable module count based on the structure of the battery pack, the SOH of the battery pack, and the prior probability distribution of the SOH of the cells or the modules in the battery pack.

5. The method of according to at least one of the previous claims, wherein the determining the posterior distribution of viable cell count and the determining the posterior distribution of viable module count is conducted from an inductive process that determines probability of viability of the cells in the battery pack from the prior probability distributions of the SOH of the cells and the SOH of the battery pack, probability of viability of the modules in the battery pack from the prior probability distributions of the SOH of the modules and the SOH of the battery pack, the inductive process being based on the structure of the battery pack.

6. The method of according to at least one of the previous claims, wherein the determining the posterior distribution of viable cell count and the determining the posterior distribution of viable module count is determined from a tensor formulation with the distribution of viable cell count and the distribution of viable module count being in a form of vectors, with nodes of a tensor graph of the tensor formulation representing tensor operators that operate on the vectors and matrix representations of the (a) probability distribution of the SOH of the cells, the modules, and other substructures in the battery pack and (b) expected viable cell count or viable module count in substructures of the battery pack.

7. The method of according to at least one of the previous claims, the determining the posterior distribution of viable cell count and the determining the posterior distribution of viable module count is conducted through a dynamic programming process comprising:

   initializing a module with a cell;
   adding a cell to the module in series to formulate a new larger module and
   computing statistics for the new module given the state of health and statistics for the cell until a defined number of cells is reached;
   initializing the battery pack with a module having the probability distribution of the SOH of the module and the expected viable cell count in the module;
   adding a module to the battery pack in parallel to formulate a new larger battery pack and computing statistics for the new battery pack given the state of health and statistics for the module and for the new larger battery pack until a defined number of modules is reached.

8. A non-transitory computer readable medium, storing instructions for processing a battery pack, the instructions comprising:

determining a structure of the battery pack and a state of health (SOH) of the battery pack;
for the SOH of the battery pack being within a first range of the viable range:

determining a posterior distribution of viable cell count for the battery pack from the structure of the battery pack, the SOH of the battery pack, and a prior probability distribution of a SOH of cells in the battery pack; and
providing the posterior distribution of viable cell count and instructions to refurbish; and

for the SOH of the battery pack being within a second range of the viable range, the second range being higher than the first range:

determining a posterior distribution of viable module count for the battery pack from the structure of the battery pack, the SOH of the battery pack, and a prior probability distribution of SOH of modules in the battery pack; and
providing the posterior distribution of viable module count and instructions to repurpose.

9. The non-transitory computer readable medium of claim 8, wherein for the SOH of the battery pack being below the viable range, providing instructions to recycle the battery pack.

10. The non-transitory computer readable medium according to at least one of the claims 8 and 9, wherein for the SOH of the battery pack being above the viable range, providing instructions to reuse the battery pack and an estimated end of life.

11. The non-transitory computer readable medium of according to at least one of the claims 8 to 10, wherein the determining the posterior distribution of viable cell count and the determining the posterior distribution of viable module count is determined from a discrete representation of the distribution of viable cell count and the distribution of viable module count based on the structure of the battery pack, the SOH of the battery pack, and the prior probability distribution of the SOH of the cells or the modules in the battery pack.

12. The non-transitory computer readable medium according to at least one of claims 8 to 11, wherein the determining the posterior distribution of viable cell count and the determining the posterior distribution of viable module count is conducted from an inductive process that determines probability of viability of the cells in the battery pack from the prior probability distributions of the SOH of the cells and the SOH of the battery pack, probability of viability of the modules in the battery pack from the prior probability distributions of the SOH of the modules and the SOH of the battery pack, the inductive process being based on the structure of the battery pack.

13. The non-transitory computer readable medium according to at least one of claims 8 to 12, wherein the determining the posterior distribution of viable cell count and the determining the posterior distribution of viable module count is determined from a tensor formulation with the distribution of viable cell count and the distribution of viable module count being in a form of vectors, with nodes of a tensor graph of the tensor formulation representing tensor operators that operate on the vectors and matrix representations of the (a) probability distribution of the SOH of the cells, the modules, and other substructures in the battery pack and (b) expected viable cell count or viable module count in substructures of the battery pack.

14. The non-transitory computer readable medium according to at least one of claims 8 to 13, the determining the posterior distribution of viable cell count and the determining the posterior distribution of viable module count is conducted through a dynamic programming process comprising:

initializing a module with a cell;
adding a cell to the module in series to formulate a new larger module and
computing statistics for the new module given the state of health and statistics for the cell until a defined number of cells is reached;
initializing the battery pack with a module having the probability distribution of the SOH of the module and the expected viable cell count in the module;

adding a module to the battery pack in parallel to formulate a new larger battery pack and computing statistics for the new battery pack given the state of health and statistics for the module and for the new larger battery pack until a defined number of modules is reached.

15. An apparatus for processing a battery pack, comprising:

a processor, configured to:

perform the method according to at least one of claims 1 to 7.

FIG. 1
(Related Art)

EP 4 534 340 A1

FIG. 2

FIG. 3

FIG. 4

Discretized SOH values

0               100

C1

S2

S3

Battery
sub-
structures

S8

S8P2

S8P3

S8P4

Computation
Sequence

S8P4

S8P3    S8

S8P2    S8

S8    S8

C

S3   C

S2   C

C   C

Adding modules S8
one-by-one in
parallel until
module reaches full
size S8P4

Adding cells C
one-by-one in
series until
module reaches
full size S8

**FIG. 5**

FIG. 6

FIG. 7

FIG. 8

Estimated Good Cell Count as a function of Pack SOH for S8P4

Estimated Good Module Count as a function of Pack SOH for S8P4

FIG. 9

**FIG. 10**

FIG. 11

Europäisches
Patentamt

European
Patent Office

Office européen
des brevets

# EUROPEAN SEARCH REPORT

**Application Number**

EP 24 19 7907

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 7 202958 B2 (HITACHI INDUSTRY EQUIPMENT SYSTEMS CO LTD) 12 January 2023 (2023-01-12) | 1-6, 8-13,15 | INV. B60L58/16 B60L58/18 |
| A | * paragraph [0002] - paragraph [0137]; figures 2,11, 12,18a, 18b * | 7,14 | G01R31/367 G01R31/392 |
| | ----- | | G01R31/396 |
| X | US 2017/108553 A1 (GANESAN NANDHINI [IN] ET AL) 20 April 2017 (2017-04-20) * figures 1,2,4,5 * | 1-15 | B60L3/00 |
| | ----- | | |

**TECHNICAL FIELDS SEARCHED (IPC)**

B60L
G01R

The present search report has been drawn up for all claims

| Place of search | Date of completion of the search | Examiner |
|---|---|---|
| The Hague | 7 February 2025 | Cuk, Vladimir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 7907

07-02-2025

| Patent document cited in search report | | Publication date | Patent family member(s) | | Publication date |
|---|---|---|---|---|---|
| JP 7202958 | B2 | 12-01-2023 | JP | 7202958 B2 | 12-01-2023 |
| | | | JP | 2020169943 A | 15-10-2020 |
| US 2017108553 | A1 | 20-04-2017 | KR | 20170045140 A | 26-04-2017 |
| | | | US | 2017108553 A1 | 20-04-2017 |

EPO FORM P0459